Europäisches Patentamt

European Patent Office

Office européen des brevets

(19)

(11) Numéro de publication: **0 076 769**
**A1**

## (12) DEMANDE DE BREVET EUROPEEN

(21) Numéro de dépôt: **82420137.0**

(22) Date de dépôt: **28.09.82**

(51) Int. Cl.³: **H 01 L 21/324**
**H 01 L 21/31**

(30) Priorité: **29.09.81 FR 8118656**

(43) Date de publication de la demande:
**13.04.83 Bulletin 83/15**

(84) Etats contractants désignés:
**CH DE GB IT LI NL**

(71) Demandeur: **CENTRE NATIONAL DE LA RECHERCHE**
**SCIENTIFIQUE (C.N.R.S.)**
**15, Quai Anatole France**
**F-75700 Paris(FR)**

(72) Inventeur: **Cohen, Joseph**
**Venon**
**F-38610 Gières(FR)**

(72) Inventeur: **Kamarinos, Georges**
**8, rue Gustave Courbet**
**F-38400 St. Martin d'Heres(FR)**

(72) Inventeur: **Chenevier, Pierre**
**9, avenue du Vercors**
**F-38240 Meylan(FR)**

(74) Mandataire: **Ropital-Bonvarlet, Claude et al,**
**Cabinet BEAU DE LOMENIE 99, Grande rue de la**
**Guillotière**
**F-69007 Lyon(FR)**

(54) Procédé de recuit superficiel par énergie micro-onde pulsée de matériaux semi-conducteurs.

(57) - Recuit de matériaux semi-conducteurs.
- Le procédé de recuit superficiel de matériau semi-conducteur est caractérisé en ce qu'on place un échantillon de matériau semi-conducteur dans une cavité résonnante, on émet une impulsion de micro-ondes à l'intérieur de la cavité et on confère à cette impulsion une durée et une puissance suffisantes pour provoquer un recuit et/ou la fusion de l'échantillon et sa recristallisation subséquente.
- Application à la cristallisation d'une couche d'un matériau semi-conducteur amorphe déposé sur un substrat.

EP 0 076 769 A1

PROCEDE DE RECUIT SUPERFICIEL PAR ENERGIE MICRO-ONDE PULSEE DE
MATERIAUX SEMI-CONDUCTEURS

La présente invention vise le domaine du traitement des matériaux semi-conducteurs et elle concerne plus particulièrement les
moyens mis en oeuvre pour assurer la cristallisation ou recristallisation superficielle de tels matériaux.

Au cours des traitements des matériaux semi-conducteurs lors de
la fabrication de dispositifs tels que diodes, transistors, circuits
intégrés, cellules solaires, etc ..., une ou plusieurs étapes nécessitent de faire des recuits. Ces recuits ont pour but de produire, suivant le cas, l'un des phénomènes suivants : cristallisation d'une
couche d'un matériau semi-conducteur amorphe déposé sur un substrat ;
recristallisation en phase solide ou fusion puis recristallisation
superficielles d'un matériau cristallin en vue d'obtenir une croissance
des grains ; reconstitution structurelle d'une couche superficielle
détruite par l'implantation ionique d'impuretés dopantes ; redistribution des impuretés dopantes au voisinage de la surface d'un matériau
semi-conducteur.

Dans les buts ci-dessus, la méthode habituellement mise en oeuvre
actuellement consiste à placer le matériau semi-conducteur à traiter
dans un four porté à température élevée et à l'y laisser un temps
suffisant.

Une telle solution technique n'est pas satisfaisante quant au
bilan énergétique. En effet, il convient de mettre en oeuvre des
moyens importants, coûteux et consommateurs d'énergie pour monter en
température une enceinte dans laquelle le matériau semi-conducteur
est disposé. De plus, le matériau semi-conducteur est maintenu pendant
de longues durées à température élevée, ce qui nécessite de travailler
en atmosphère parfaitement contrôlée pour éviter toute pollution par le
milieu environnant. En outre, ces installations ne permettent pas des
modifications aisées des paramètres de traitement.

Par ailleurs, avec une telle installation il n'est pas possible
d'obtenir une fusion superficielle qui permettrait, à partir d'une couche implantée en impuretés dopantes, d'obtenir, après recristallisation, une couche uniformément dopée.

Il est aussi possible de procéder au traitement de matériaux semi-conducteurs en utilisant un faisceau laser dirigé sur la surface d'un matériau à traiter. Un tel moyen technique paraît plus adapté aux traitements de couches superficielles et présente en ce sens un avantage par rapport à la solution précédente.

Cependant, le laser est connu pour disposer d'un faible rendement, ce qui implique une consommation d'énergie importante pour l'exécution de tels traitements.

Par ailleurs, la mise en oeuvre d'un faisceau laser ne peut être pratiquement envisagée qu'en faisant intervenir un balayage de la surface à traiter. Etant donné que la zone traitée pour chaque balayage est de faible surface, il en résulte un défaut d'homogénéité qui est préjudiciable, parfois incompatible, voire rédhibitoire avec le but visé tel que, par exemple, la recristallisation de surface ou la croissance de grains.

En outre, il faut noter que les deux solutions techniques ci-dessus ne se prêtent pas à l'obtention de dopages dont les profils de concentration sont à front raide.

La présente invention vise à remédier aux inconvénients ci-dessus en proposant un nouveau procédé de recuit superficiel de matériaux semi-conducteurs permettant de réaliser, très rapidement et avec un excellent bilan énergétique, le traitement de matériaux semi-conducteurs et, notamment, le traitement superficiel par cristallisation ou recristallisation.

Un objet de l'invention est d'offrir un procédé pouvant être mis en oeuvre de façon rapide, pratique, fiable et de façon quasi instantanée, c'est-à-dire ne nécessitant pas une phase préalable de préparation des installations de traitement comme celle, par exemple, de montée en température initiale des fours thermiques.

Un autre objet de l'invention est de proposer un nouveau procédé qui ne fasse pas intervenir en fin de traitement une phase d'attente ou de repos avant de passer à l'étape technologique suivante.

Un autre avantage de l'invention est d'offrir un procédé de traitement qui puisse être mis en oeuvre en chambre blanche sans nécessiter d'installation complexe destinée à éviter la pollution du matériau semi-conducteur.

Pour atteindre les buts ci-dessus, l'invention est caractérisée en ce qu'on place un échantillon de matériau semi-conducteur dans une cavité résonnante, on émet une impulsion de micro-ondes à l'intérieur de la cavité et on confère à cette impulsion une durée et une puissance suffisantes pour provoquer un recuit et/ou la fusion superficielle de l'échantillon et sa recristallisation subséquente.

Diverses autres caractéristiques de l'objet de l'invention ressortent de la description détaillée qui suit.

Selon l'invention, le procédé de traitement de matériau semi-conducteur consiste à placer un tel matériau dans une cavité résonnante couplée, par l'intermédiaire d'un guide d'ondes, à un générateur micro-onde pouvant être constitué par un magnétron ou, de préférence, par une chaîne se terminant par un klystron amplificateur permettant de régler ou de moduler le rayonnement émis.

Une telle installation n'est pas décrite dans ce qui suit étant donné qu'elle fait intervenir, pour la constitution, la mise en oeuvre des connaissances techniques de l'homme de métier relatives à l'émission et au confinement des micro-ondes. La cavité est cependant couplée au générateur de façon qu'elle absorbe pratiquement toute la puissance émise par ce dernier.

La partie du matériau semi-conducteur à traiter au cours d'une impulsion est située dans une région où le champ électrique est uniforme et se trouve disposée en sorte qu'elle constitue une partie de la paroi de réflexion de ladite cavité, de manière à constituer ou représenter au moins partiellement une paroi de réflexion de ladite cavité.

L'échantillon semi-conducteur est soumis à l'énergie micro-ondes pendant une durée déterminée, de manière à élever sa température superficielle à la valeur requise pour le traitement désiré.

Par exemple, pour restructurer en phase solide un échantillon de silicium amorphisé par implantation ionique, on envoie une puissance de l'ordre de 1 kw par cm2 de matériau pendant 200 ms, à une fréquence de 8 GHz. Avec les générateurs du commerce, on peut ainsi traiter en une seule impulsion des surfaces atteignant quelques dizaines de cm2.

Toujours à titre d'exemple, on obtient une fusion superficielle du silicium avec une impulsion de 2 kw par cm2 pendant 200 ms à 8 GHz.

Cependant, ce type de traitement doit être beaucoup plus bref, ce qui entraîne des puissances d'irradiation beaucoup plus élevées, par exemple 200 kw par cm2 pendant 1 ms.

Pour des raisons de facilité de mise en oeuvre pour les grandes surfaces et de disponibilité en puissance des générateurs du commerce, il est intéressant d'abaisser la fréquence. Cependant, la densité de puissance nécessaire croît comme l'inverse de la racine carrée de la fréquence, toutes choses étant égales par ailleurs.

Soit $T_o$ le temps caractéristique de diffusion de la chaleur dans le matériau sur une profondeur égale à son épaisseur de peau pour la fréquence considérée. Si la durée de l'impulsion est inférieure à $T_o$, le traitement s'effectue sur une profondeur sensiblement égale à l'épaisseur de peau ; par exemple, pour le silicium, 10 $\mu$m à 10 GHz et 30 $\mu$m à 1 GHz. Au contraire, si la durée de l'impulsion est supérieure à $T_o$, le traitement s'effectue sur une profondeur sensiblement proportionnelle à la racine carrée de la durée de l'impulsion. On peut donc, en ajustant suivant les cas, les puissance et durée du rayonnement micro-onde, faire les différents traitements cités plus haut, à savoir : cristallisation d'une couche d'un matériau semi-conducteur amorphe déposé sur un substrat ; recristallisation en phase solide ou fusion, puis recristallisation superficielles d'un matériau cristallin en vue d'obtenir une croissance des grains ; reconstitution structurelle d'une couche superficielle détruite par l'implantation ionique d'impuretés dopantes ; redistribution des impuretés dopantes au voisinage de la surface d'un matériau semi-conducteur.

Le procédé de l'invention peut donc être mis en oeuvre pour le traitement des semi-conducteurs au sens général pouvant être utilisés dans la construction d'un nombre important de dispositifs en vue d'applications diverses, tels que des diodes, transistors, circuits intégrés, cellules solaires, etc ...

L'un des avantages du procédé de l'invention réside dans le fait que la montée en température quasi immédiate et le refroidissement subséquent permettent d'obtenir des zones traitées de profondeurs et de surfaces contrôlables et reproductibles conférant à des échantillons de matériaux semi-conducteurs traités des caractéristiques homogènes. En outre, dans le cas de fusion superficielle, étant donné que la montée en température s'effectue en un temps bref, quasi instantané, les impuretés dopantes éventuelles introduites préalablement dans le matériau semi-conducteur se répartissent uniformément de façon instantanée dans la zone fondue ou dans l'épaisseur de la couche superficielle fondue et ne pénètrent que peu ou pas dans le milieu sous-jacent. Il en résulte la possibilité, dans un tel cas d'application, d'obtenir des profils de dopage en impuretés à front raide et reproductibles d'un échantillon à un autre.

Outre la possibilité de contrôler la profondeur de traitement, il y a lieu de noter que le procédé de l'invention fait intervenir un gradient thermique faible imposé au matériau traité. Il en résulte peu de contraintes internes au niveau des zones frontières entre les surfaces exposée et non exposée.

Par ailleurs, le fait de placer le matériau semi-conducteur à l'intérieur d'une cavité résonnante permet de lui faire absorber pratiquement toute l'énergie émise par le générateur. Un rendement de 80 % de l'énergie émise est ainsi obtenu et permet de réaliser un traitement à un coût particulièrement bas comparativement aux procédés actuellement connus et utilisés.

Le procédé selon l'invention peut être mis en oeuvre pour le traitement de matériaux semi-conducteurs dopés ou non. Dans la mesure où le matériau n'est pas suffisamment conducteur à froid, le procédé de l'invention prévoit de le rendre absorbant aux micro-ondes par effet de génération de porteurs libres. Cet effet est provoqué en soumettant au cours du traitement le matériau semi-conducteur à un rayonnement lumineux, soit à large spectre, soit à spectre étroit adapté à la nature du matériau. Dans ce dernier cas, l'énergie des photons doit être supérieure à la largeur de la bande interdite du semi-conducteur. A titre d'exemple, le rayonnement peut être émis par une source lumineuse d'une puissance de 300 W placée à 5 cm de la surface à traiter, ces conditions étant réunies pour l'exposition d'une surface d'un cm2.

L'illumination de l'échantillon peut se faire par l'intermédiaire d'un guide à la coupure débouchant dans la cavité face au matériau à traiter.

Il se peut que la puissance mise en jeu soit telle qu'elle entraîne une densité d'énergie trop importante (apparition de claquages) dans une cavité remplie d'air à la pression atmosphérique.
Dans ce cas, le procédé de l'invention prévoit de remplir la cavité
résonnante avec un matériau diélectrique de forte rigidité diélectrique tel que le polytétrafluorure d'éthyle, le polystyrène transparent, le quartz, l'hexafluorure de soufre, l'air comprimé ou
l'huile de vaseline.

Dans la mesure où le matérieu diélectrique utilisé présente un
caractère polluant vis-à-vis du matériau semi-conducteur à traiter,
il est prévu d'isoler ce dernier en faisant intervenir une fenêtre
non absorbante au rayonnement micro-ondes et en une matière non polluante pour l'échantillon de matériau semi-conducteur. Une telle fenêtre
peut être réalisée à base de quartz.

L'invention n'est pas limitée à l'exemple représenté et décrit
ci-dessus, car diverses modifications peuvent y être apportées sans
sortir de son cadre.

REVENDICATIONS :

1 - Procédé de recuit superficiel de matériau semi-conducteur, caractérisé en ce qu'on place un échantillon de matériau semi-conducteur dans une cavité résonnante, on émet une impulsion de micro-ondes à l'intérieur de la cavité et on confère à cette impulsion une durée et une puissance suffisantes pour provoquer un recuit et/ou la fusion de l'échantillon et sa recristallisation subséquente.

2 - Procédé selon la revendication 1, caractérisé en ce qu'on émet, pendant une durée comprise entre 500 ms et 10 $\mu$s, une impulsion de micro-ondes de fréquence comprise entre 1 GHz et 12 GHz avec une puissance comprise entre 500 W et 200 kW par cm2 d'échantillon.

3 - Procédé selon la revendication 1 ou 2, caractérisé en ce qu'on place l'échantillon dans une cavité résonnante remplie d'un matériau diélectrique.

4 - Procédé selon la revendication 3, caractérisé en ce que le matériau diélectrique est choisi parmi le polytétrafluorure d'éthylène, le polystyrène transparent, le quartz, l'hexafluorure de soufre, l'air comprimé, l'huile de vaseline.

5 - Procédé selon la revendication 3 ou 4, caractérisé en ce que l'échantillon est isolé du matériau diélectrique par une fenêtre diélectrique non absorbante et non polluante pour l'échantillon.

6 - Procédé selon l'une des revendications 1 à 5, caractérisé en ce que l'échantillon est placé dans la cavité résonnante en constituant une partie de la paroi de réflexion de cette dernière et dans une région du champ électrique homogène.

7 - Procédé selon la revendication 1 ou 2, caractérisé en ce qu'on excite l'échantillon par une exposition simultanée à la lumière.

8 - Procédé selon la revendication 7, caractérisé en ce qu'on place la source lumineuse dans un guide d'ondes à la coupure débouchant dans la cavité.

**Office européen des brevets**

**RAPPORT DE RECHERCHE EUROPEENNE**

**0076769**
Numéro de la demande

EP    82  42  0137

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| | --- | | H 01 L    21/324 |
| A | EP-A-0 015 677  (VLSI TECHNOLOGY ASSOCIATION) *Revendication 1* | 1 | H 01 L    21/31 |
| | --- | | |
| A | DE-A-2 927 824  (VLSI TECHNOLOGY ASSOCIATION) *Revendication 1* | 1 | |
| | --- | | |
| A | US-A-4 231 809  (SCHMIDT) *Revendications 1,3,4* | 1 | |
| | --- | | |
| A | US-A-4 154 873  (HICKOX et al.) *Revendication 1* | 1 | |
| | --- | | |
| A | US-A-4 113 514  (PANKOVE et al.) *Revendication  1;   colonne  2, lignes 44-47* | 1 | **DOMAINES TECHNIQUES RECHERCHES (Int. Cl. ³)** |
| | --- | | |
| A | FR-A-2 382 097  (R.T.C. LA RADIOTECHNIQUE-COMPELEC) *Revendications 1-5* | 1 | H 01 L    21/324 H 05 B     6/64 H 05 B     6/80 C 22 F     3/00 H 01 L    21/31 |
| | --- | | |
| A | FR-A-2 394 173  (THOMSON-CSF) *Revendications 1,4* | 1 | |
| | ----- | | |

Le présent rapport de recherche a été établi pour toutes les revendications

| Lieu de la recherche LA HAYE | Date d'achèvement de la recherche 04-01-1983 | Examinateur LIPPENS M.H. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82